**Europäisches Patentamt**

(19) **European Patent Office**

**Office européen des brevets**

(11) Veröffentlichungsnummer: **0 001 586**
**B1**

(12) # EUROPÄISCHE PATENTSCHRIFT

(45) Veröffentlichungstag der Patentschrift:
23.09.81

(51) Int. Cl.³: **H 01 L 27/08**, H 01 L 21/70

(21) Anmeldenummer: **78101056.6**

(22) Anmeldetag: **03.10.78**

(54) Integrierte Halbleiteranordnung mit vertikalen NPN- und PNP-Strukturen und Verfahren zur Herstellung.

(30) Priorität: **25.10.77 US 844767**

(43) Veröffentlichungstag der Anmeldung:
**02.05.79 Patentblatt 79/9**

(45) Bekanntmachung des Hinweises auf die Patenterteilung:
**23.09.81 Patentblatt 81/38**

(84) Benannte Vertragsstaaten:
**DE FR GB**

(56) Entgegenhaltungen:
**DE-A-2 525 529**
**DE-A-2 624 409**
**US-A-3 930 909**

(73) Patentinhaber: **International Business Machines Corporation, Armonk, N.Y. 10504 (US)**

(72) Erfinder: **Anantha, Narasipur Gundappa, 1 Valdemar Road, Hopewell Junction New York 12533 (US)**
Erfinder: **Bhatia, Harsaran Singh, 41 Tor Road, Wappingers Falls New York 12590 (US)**
Erfinder: **Walsh, James Leo, 23 South Drive, Hyde Park New York 12538 (US)**

(74) Vertreter: **Gaugel, Heinz, Dipl.-Ing., Schönaicher Strasse 220, D-7030 Böblingen (DE)**

## Integrierte Halbleiteranordnung mit vertikalen NPN- und PNP-Strukturen und Verfahren zur Herstellung

Die Erfindung betrifft eine integrierte Halbleiteranordnung mit vertikalen PNP- und NPN-Strukturen, bei der jede der Strukturen in einem von durch Isolationszonen getrennten Bereichen einer auf ein Substrat eines ersten Leitungstyps aufgebrachten Epitaxieschicht des entgegengesetzten zweiten Leitungstyps angeordnet ist, bei der innerhalb wenigstens eines Bereiches im Grenzgebiet zwischen Substrat und Epitaxieschicht eine vergrabene Zone des zweiten Leitungstyps vorhanden ist und bei der in einem ersten Bereich eine vergrabene Zone des ersten Leitungstyps angeordnet und über eine gleichartig dotierte Anschlußzone an die Oberfläche geführt ist, sowie ein Verfahren zur Herstellung einer derartigen Halbleiteranordnung.

Eine Halbleiteranordnung der obengenannten Art ist aus der US-A-3 930 909 bekannt.

In der integrierten Halbleitertechnik ist es normalerweise erforderlich, die verschiedenen aktiven und passiven Elemente innerhalb der integrierten Struktur gegeneinander zu isolieren. Dies erreicht man durch sperrende PN-Übergänge, durch teilweise dielektrische Isolation und auch durch vollständige dielektrische Isolation. Als dielektrische Materialien verwendet man Siliziumdioxid, Glas usw. Als bevorzugte Isolationsmethode, insbesondere im Hinblick auf die erreichbare Integrationsdichte, hat sich die dielektrische Isolation erwiesen. Die Vorteile der dielektrischen Isolation gegenüber der PN-Sperrschichtisolation sind darin zu sehen, daß die Schaltungselemente direkt an die Isolationszonen anstoßen dürfen. Auf diese Weise erreicht man eine extrem hohe Packungsdichte innerhalb einer integrierten Halbleiteranordnung.

In den durch Isolationszonen abgegrenzten monolithischen Siliziumbereichen werden die aktiven und passiven Halbleiterbauelemente gebildet. Die wesentlichen Verfahrensschritte sind beispielsweise dem Buch »Modern Microelectronics« von Max Fogiel, veröffentlicht durch Research and Education Assoc., 342 Madison Avenue, New York, N. Y. 10017, 1972, Seiten 463 bis 472, zu entnehmen. Zusammengefaßt besteht ein solches Verfahren darin, daß beispielsweise die Oberfläche eines P-leitenden Halbleitersubstrats aus Silizium oxidiert wird, ein Fenster in der gebildeten Siliziumdioxidschicht unter Anwendung der üblichen Photolithographie und Ätztechnik geöffnet und durch dieses Fenster eine N+-leitenden Zone eindiffundiert wird. Die Siliziumdioxidschicht wird entfernt. Anschließend wird auf die Oberfläche des so vorbereiteten Halbleitersubstrats eine N-leitende Epitaxieschicht aus Silizium aufgewachsen. Dabei diffundiert die vergrabene Zone in die entstehende Epitaxieschicht aus. Die vergrabene Zone wird im betrachteten Beispiel als Subkollektor eines NPN-Transistors verwendet. Auf die Epitaxieschicht wird eine weitere Siliziumdioxidschicht aufgebracht, in der wiederum mittels Photolithographie und Ätztechnik Fenster für das Einbringen von Isolationszonen geöffnet werden. Nach dem Einbringen der Isolationszonen erhält man innerhalb der Epitaxieschicht gegeneinander isolierte Bereiche monokristallinen Siliziums. Innerhalb der isolierten Bereiche werden dann in bekannter Weise die erforderlichen, die aktiven und passiven Bauelemente bildenden Halbleiterübergänge erzeugt.

Bei der Herstellung integrierter Halbleiteranordnungen mit einer Mehrzahl von PNP-Transistoren und NPN-Transistoren innerhalb eines Halbleiterkörpers hat sich bisher kein Verfahren als praktisch vorteilhaft erwiesen, wenn vertikale NPN- und vertikale PNP-Transistoren zu verwirklichen sind. Bei der Herstellung solcher Strukturen sind hinsichtlich der elektrischen Eigenschaften der erzielten Transistoren Kompromisse zu schließen. Diese Kompromisse führen gewöhnlich zu einer niedrigen Stromverstärkung und zu einem hohen Sättigungswiderstand der PNP-Transistoren. Die PNP-Transistoren sind damit in ihren Eigenschaften den NPN-Transistoren unterlegen.

Bei einem bekannten Herstellungsverfahren werden die NPN- und PNP-Transistoren durch eine Doppeldiffusion nacheinander hergestellt. Ein solches Verfahren erfordert eine sehr komplexe Prozeßsteuerung, da sich die Fronten früherer Diffusionen bei der Durchführung späterer Diffusionen unerwünscht verschieben.

Eine weitere Methode zur Lösung des geschilderten Problems besteht darin, daß vertikale NPN-Transistoren und laterale PNP-Transistoren gleichzeitig hergestellt werden. Die laterale Struktur ist so aufgebaut, daß die Halbleiterschicht die Basis bildet, in die in lateraler Anordnung die Emitter- und Kollektorzonen eingebracht sind. Die Emitter- und Kollektorzone des lateralen PNP-Transistors können gleichzeitig mit dem Einbringen der Basiszone des doppeldiffundierten NPN-Transistors hergestellt werden. Das bedeutet, daß nach der Bildung des NPN-Transistors keine weiteren Hochtemperaturprozesse erforderlich sind. Die auf diese Weise hergestellten lateralen PNP-Transistoren sind mit dem Nachteil behaftet, daß der Stromverstärkungsfaktor sehr niedrig ist und mit zunehmendem Emitterstrom rasch abfällt. Die Herstellung komplementärer Anordnungen in Form von vertikalen NPN-Transistoren und lateralen PNP-Transistoren ist beispielsweise im US-Patent Nr. 3 971 059 beschrieben.

Eine andere Lösungsmöglichkeit ergibt sich aus der US-Patentschrift Nr. 3 611 067. Dort wird ein doppeltdiffundierter NPN-Transistor und ein PNP-Transistor in vertikaler Struktur angewendet, der einen diffundierten Emitter, eine epitaktische Basis und einen Schottky-Kollektor aufweist. Die Tatsache, daß eine epitaktisch aufgewachsene Basis erforderlich ist, macht den Herstellungsprozeß außerordentlich kompliziert.

Während des epitaktischen Aufwachsen der monokristallinen Basiszone verursacht das Aufwachsen von Polysilizium auf anderen Oberflächenbereichen eine Verschiebung der bereits eindiffundierten Halbleiterzonen. Dadurch wird das Verstärkungs- und Frequenzverhalten des PNP-Transistors ungünstig beeinflußt.

Auch in der Veröffentlichung »IBM TDB Vol. 15, No. 1, June 1972, Seite 261, ist die Verwendung von Schottky-Kollektoren für PNP-Strukturen angegeben. Der hier offenbarte PNP-Transistor hätte zumindest deswegen schlechtere Charakteristiken, weil der hochdotierte, vergrabene Emitter während des anzuwendenden Epitaxieprozesses beträchtlich ausdiffundieren würde.

Auch in den US-Patentschriften 3 861 968, 3 930 909 und 3 999 080 sind komplementäre PNP- und NPN-Transistoren beschrieben. Diese Strukturen erfordern bei ihrer Herstellung sehr komplexe Verfahrensschritte, so daß ihre praktische Verwendung nicht anzustreben ist.

Schließlich werden in den US-Patentschriften 3 648 130, 3 922 565 und 4 005 469 integrierte Transistoren mit Schottky-Kollektoren beschrieben. Eine Lösung der bei vertikalen PNP- und NPN-Strukturen auftretenden Probleme ist jedoch nicht angesprochen.

Hier will die Erfindung Abhilfe schaffen. Die Erfindung, wie sie in den Ansprüchen gekennzeichnet ist, löst die Aufgabe, eine integrierte Halbleiteranordnung mit vertikalen, komplementären NPN- und PNP-Strukturen zu schaffen, die optimale Betriebscharakteristiken aufweisen und sich in einem relativ einfachen Verfahren herstellen lassen.

Zusammenfassend stellt sich ein Ausführungsweg des erfindungsgemäßen Verfahrens folgendermaßen dar. In ein monokristallines Halbleitersubstrat aus Silizium wird zunächst ein Muster von N-leitenden Zonen eingebracht. Anschließend wird eine Epitaxieschicht auf die Oberfläche des Halbleitersubstrats aufgewachsen, wobei die N-leitenden Zonen in die Epitaxieschicht ausdiffundieren. In die Epitaxieschicht werden Isolationszonen eingebracht, die Bereiche umschließen, in denen eine der genannten, N-leitenden Zonen liegen. Durch Diffusion oder Ionenimplantation wird in den Bereichen der Epitaxieschicht, in denen ein NPN-Transistor zu verwirklichen ist, eine P-dotierte Basiszone eingebracht. Gleichzeitig wird in den Bereichen, in denen ein PNP-Transistor zu bilden ist, eine entsprechende P-dotierte Anschlußzone eingebracht. Die Emitterzone des NPN-Transistors und die Basisanschlußzone des PNP-Transistors werden ebenfalls gleichzeitig eingebracht. Die P-dotierte Emitterzone des PNP-Transistors wird durch Ionenimplantation hergestellt. Diese Technik bietet den Vorteil, daß diese Zone in einer vorbestimmten Tiefe, abhängig von der Energie und der Dosis der Implantation, angeordnet werden kann. Im Bereich des PNP-Transistors wird ein einen Schottky-Kollektor bildender Metallkontakt aufgebracht. Schließlich werden die einzelnen Zonen der beiden Transistoren mit elektrischen Kontakten versehen.

Die Maßnahme, den invertierten, vertikalen PNP-Transistor mit einer implantierten, vergrabenen Emitterzone und mit einem Schottky-Kollektor auszustatten bietet den Vorteil, vertikale, komplementäre Transistorstrukturen herzustellen, die nicht die Nachteile der entsprechenden bekannten Strukturen aufweisen. Die Herstellung der ionenimplantierten Emitterzone und des Schottky-Kollektors erfolgt bei relativ niedrigen Temperaturen, so daß zuvor eingebrachte Halbleiterzonen nicht beeinflußt werden. Die erfindungsgemäße Halbleiterstruktur hat gute Verstärkungscharakteristiken und einen sehr niedrigen Kollektorwiderstand. Da der Kollektor-Basisübergang ein Schottkyübergang ist, treten die normalerweise festzustellenden Sättigungseigenschaften nicht auf. Der Kollektor injiziert keine Minoritätsladungsträger in die Basis, so daß sich ein Transistor mit weit weniger Speichereffekten in der Basis ergibt, als dies bei üblichen PNP-Transistoren der Fall ist. Ein Ausführungsbeispiel der bei dem erfindungsgemäßen Verfahren gebildete Halbleiteranordnung besteht also aus vertikalen NPN- und PNP-Strukturen in einem Halbleiterkörper, der sich aus einem Halbleitersubstrat mit einer darauf aufgewachsenen N-dotierten Epitaxieschicht zusammensetzt. Die einzelnen Bereiche für NPN- bzw. PNP-Strukturen sind durch vorzugsweise dielektrische Isolationszonen in der Epitaxieschicht gegeneinander abgegrenzt. Eine vergrabene, N-dotierte Zone überlappt den Übergang zwischen Substrat und Epitaxieschicht. Diese vergrabene Zone ist in mindestens einem der genannten isolierten Bereiche der Epitaxieschicht vorhanden. Ein NPN-Transistor wird in mindestens einem dieser Bereiche gebildet. In diesem Falle dient die N-dotierte, vergrabene Zone als Subkollektor dieses Transistors. Dieser Subkollektor ist über eine Kollektoranschlußzone mit der Oberfläche der Epitaxieschicht verbunden. In einem seitlichen Abstand zur Kollektoranschlußzone ist eine Basiszone eingebracht. Innerhalb dieser Basiszone ist eine Emitterzone gebildet. In einem anderen dieser isolierten Bereiche der Epitaxieschicht ist ein PNP-Transistor gebildet. Dieser Transistor weist einen vergrabenen, P-dotierten Emitter auf, der über eine entsprechende Anschlußzone an die Oberfläche der Epitaxieschicht geführt ist. Über dieser Emitterzone liegt die N-dotierte Basiszone. Auf der Basiszone ist ein Metallkontakt angeordnet, der einen Schottky-Kollektor bildet. Vervollständigt werden diese Strukturen durch elektrische Kontakte an der Emitter-, Basis- und Kollektorzone des NPN-Transistors und an der Emitter-, Basis- und Kollektorzone des PNP-Transistors.

Die vergrabene N-dotierte Zone ist vorzugsweise auch im Bereich eines PNP-Transistors vorgesehen. Dabei ist auch diese Zone über eine Anschlußzone an die Oberfläche der Epitaxieschicht geführt. In diesem Falle bildet diese vergrabene, N-dotierte Zone mit dem Halbleitersubstrat, das normalerweise P-dotiert ist, einen PN-Übergang. Dieser Übergang wird in Sperrrichtung vorgespannt, so daß der PNP-Transistor gegen das Halbleitersubstrat isoliert ist und unerwünschte Transistorwirkungen und Streukapazitäten verhindert werden.

In manchen Anwendungen ist es anzustreben, die Schottky-Dioden entweder in isolierten Bereichen einer PNP-Transistorstruktur oder innerhalb des für einen derartigen Transistor vorgesehenen Bereiches selbst vorzusehen. Die Schottky-Dioden können elektrisch mit dem PNP-Transistor verbunden werden, so daß eine Dioden-Transistor-Logik entsteht. Hierbei ist keine sättigungsverhindernde zusätzliche Diode erforderlich. Der Kollektorwiderstand ist praktisch Null.

Die Erfindung wird im folgenden anhand der lediglich einen Ausführungsweg darstellenden Zeichnungen näher erläutert. Es zeigt

Fig. 1 bis 10 das erfindungsgemäße Verfahren zur Herstellung vertikaler NPN- und PNP-Strukturen anhand einzelner, jeweils am Ende aufeinanderfolgender Verfahrensschritte verwirklichter Strukturen,

Fig. 11 und 12 zwei Ausführungsbeispiele erfindungsgemäßer, integrierter PNP- und Schottky-Dioden-Strukturen,

Fig. 13 das Schaltbild einer konventionellen Dioden-Transistor-Logik und

Fig. 14 das Ersatzschaltbild der in den Fig. 11 und 12 dargestellten Kombination aus PNP-Transistor und Schottky-Dioden.

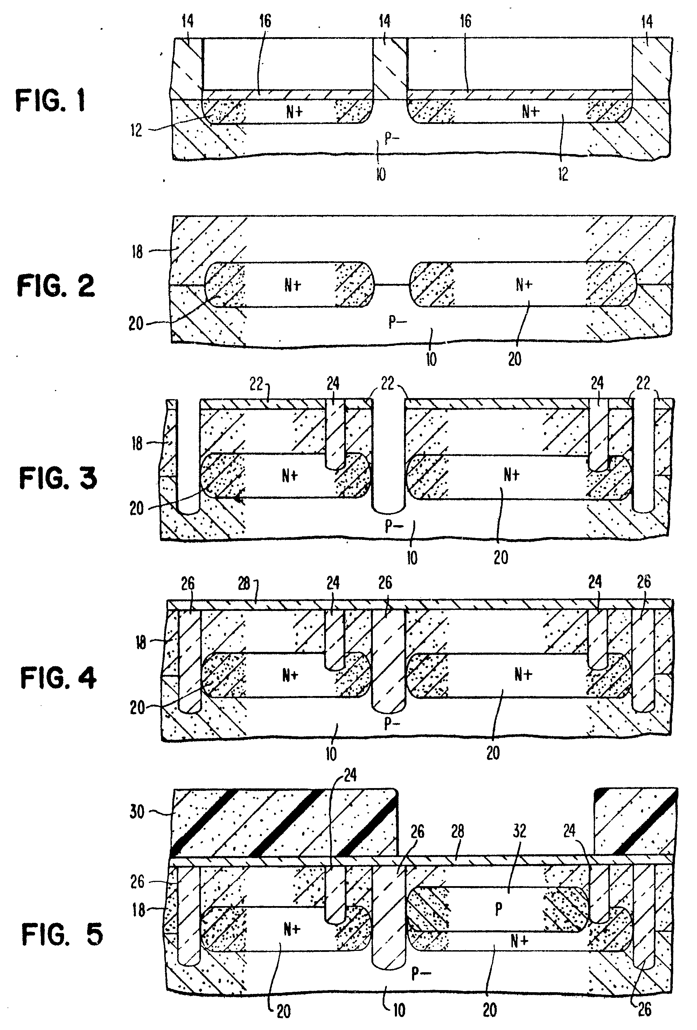

Zunächst seien die zur Herstellung der Strukturen gemäß Fig. 1 bis 10 erforderlichen Verfahrensschritte näher betrachtet. Ausgegangen wird von einem Halbleitersubstrat 10 aus P$^-$-dotiertem Silizium. In das Substrat 10 werden hochdotierte Zonen 12 des entgegengesetzten Leitungstyps also im betrachteten Beispiel N$^+$-dotierte Zonen eingebracht. Dies kann beispielsweise durch Ionenimplantation oder konventionelle Diffusion von entsprechenden Störstellen erreicht werden. Dazu wird auf das Substrat zunächst eine Isolationsschicht 14 aus Siliziumdioxid durch thermische Oxidation aufgebracht. Die bevorzugte Dicke dieser Siliziumdioxidschicht beträgt beispielsweise 300 nm. Durch Anwendung der konventionellen Photolithographie- und Ätztechnik werden in diese Siliziumdioxidschicht Fenster eingeätzt. Im Bereich dieser Fenster wird erneut eine Siliziumdioxidschicht 16 aufgewachsen, die beispielsweise eine Dicke im Bereich von 25 bis 30 nm aufweist. Diese Siliziumdioxidschicht dient als Schirm bei der nachfolgenden Ionenimplantation. Die Parameter beim Implantationsprozeß werden so gewählt, daß eine vergrabene Zone mit einem Schichtwiderstand von 8 bis 10 Ohm/Flächenquadrat nach dem dem eigentlichen Implantationsprozeß folgenden Temperaturzyklus erreicht wird. Bei dem Temperaturzyklus werden die implantierten Störstellen, beispielsweise Arsen, weiter in das P-dotierte Substrat eingetrieben und die Oberfläche des Substrats weiter oxidiert. Anschließend werden die Siliziumdioxidschichten 14 und 16 abgeätzt.

Auf die Oberfläche des Substrates 10, 12 wird anschließend eine Epitaxieschicht 18 aufgewachsen, wie es in Fig. 2 dargestellt ist. Die Dicke dieser Epitaxieschicht richtet sich nach dem jeweils angestrebten Zweck, im Rahmen der vorliegenden Erfindung sollte die Dicke geringer als etwa 2 µm sein. Vorzugsweise liegt die Dicke der Epitaxieschicht bei etwa 1,2 µm. Der Epitaxieprozeß wird in konventioneller, in der integrierten Halbleitertechnik üblichen Weise durchgeführt. Während des Prozesses diffundieren Störstellen aus der Zone 20 in die Epitaxieschicht ein. Dadurch ergeben sich N$^+$-dotierte Zonen 20, die als Subkollektor eines NPN-Transistors und/oder als Isolationszone in Form eines sperrenden PN-Überganges für einen PNP-Transistor dienen. Bei den nächsten Verfahrensschritten handelt es sich um reaktives Ionenätzen. Dazu wird auf konventionelle Weise zunächst eine Siliziumdioxidschicht 22 aufgebracht. Außer Siliziumdioxid sind auch andere Maskenmaterialien wie beispielsweise Siliziumnitrid oder Aluminiumoxid verwendbar. Ein erster Oxidationsprozeß dient der Herstellung einer Isolationszone zwischen der Basis und der Subkollektoranschlußzone des NPN-Transistors und der Isolationszone zwischen der Basis und der vergrabenen Isolationszone 20 des PNP-Transistors. Für diesen Zweck werden an diesen Stellen Fenster auf dem üblichen photolithographischen Wege in die Siliziumdioxidschicht 22 eingeätzt. Daraufhin erfolgt das reaktive Ionenätzen, wobei schmale, bis in die vergrabenen N$^+$-dotierten Zonen 20 reichende Einschnitte oder Kanäle gebildet werden, in denen anschließend die Isolationszonen 24 untergebracht werden. Ein hier anwendbarer Prozeß des reaktiven Ionenätzens ist in der DE-OS 2 617 483 beschrieben.

Die Siliziumdioxidschicht 22 wird nun auf konventionellem Wege entfernt. Anschließend wird auf pyrolithischem Wege erneut Siliziumdioxid niedergeschlagen. Dabei werden die genannten Kanäle mit pyrolithischem Siliziumdioxid aufgefüllt, so daß die Isolationszonen 24 entstehen.

Ein zweiter reaktiver Ätzprozeß dient der Herstellung der Kanäle oder Einschnitte, in denen die die einzelnen NPN-, PNP-Strukturen trennenden Isolationszonen unterzubringen sind. Dazu werden entsprechende Öffnungen in der vorhandenen Siliziumdioxidschicht auf konventionellem, photolithographischem Wege festgelegt und freigeätzt. Es erfolgt der zweite reaktive Ätzprozeß, wobei die Kanäle bis zur gewünschten Tiefe gebildet werden. Vorzugsweise erstrecken sich die Kanäle über die vergrabenen Zonen 20 hinaus bis in das Substrat 10 (Fig. 3). Im nächsten Verfahrensschritt werden die gebildeten Kanäle thermisch oxidiert, wobei diese Kanäle mit Siliziumdioxid aufgefüllt werden. Auf diese Weise entstehen die Isolationszonen 26, wie sie in Fig. 4 dargestellt sind. Die Anwendung der thermischen Oxidation gewährleistet ausgezeichnete Grenzflächeneigenschaften zwischen dem Silizium und dem Siliziumdioxid, was bei chemischem Aufdampfen nicht sichergestellt ist. Die Verwendung von qualitativ hochwertigem, dielektrischem Material ist erforderlich, damit die nachfolgend einzudiffundierenden Halbleiterübergänge an die dielektrischen Isolationszonen anstoßen können. Das vollständige Auffüllen der Kanäle mit geeignetem dielektrischem Material erfolgt durch pyrolithischen Niederschlag von Siliziumdioxid.

In manchen Fällen kann es von Vorteil sein, vor dem pyrolithischem Niederschlagsprozeß Borionen durch das Oxid am Grunde der Kanäle zu implantieren. Dabei wird unterhalb der Isolationszone eine P+-dotierte Zone gebildet, die verhindert, daß das P−-leitende Material unterhalb der Isolationszone in N-leitendes Material übergeht.

Im folgenden Verfahrensschritt wird wiederum durch reaktives lonenätzen der chemisch aufgedampften Siliziumdioxidschicht das überschüssige Siliziumdioxid von der Oberfläche entfernt.

Der Fig. 4 ist die komplette Isolationsstruktur mit den dielektrischen Isolationszonen 24 und 26 zu entnehmen. Die Oberfläche der Anordnung wird thermisch reoxidiert, um die Siliziumdioxidschicht 28 auf die gewünschte Dicke zu bringen.

Die Fig. 5 verdeutlicht den Prozeßschritt, bei dem ein vergrabener, P-dotierter Emitter 32 des PNP-Transistors implantiert wird. Dabei wird zunächst in einem photolithographischen Ätzprozeß eine aufgebrachte Photolackschicht 30 belichtet, entwickelt und darin ein Fenster freigeätzt, in dessen Bereich die lonenimplantation erfolgen soll. Als Ergebnis einer mit geeigneten Parametern durchgeführten Implantation von Bor erhält man den P-dotierten Emitter 32. Während des Implantationsprozesses kann dabei die dünne Siliziumdioxidschicht 28 in bekannter Weise als Schirm auf der Oberfläche belassen werden.

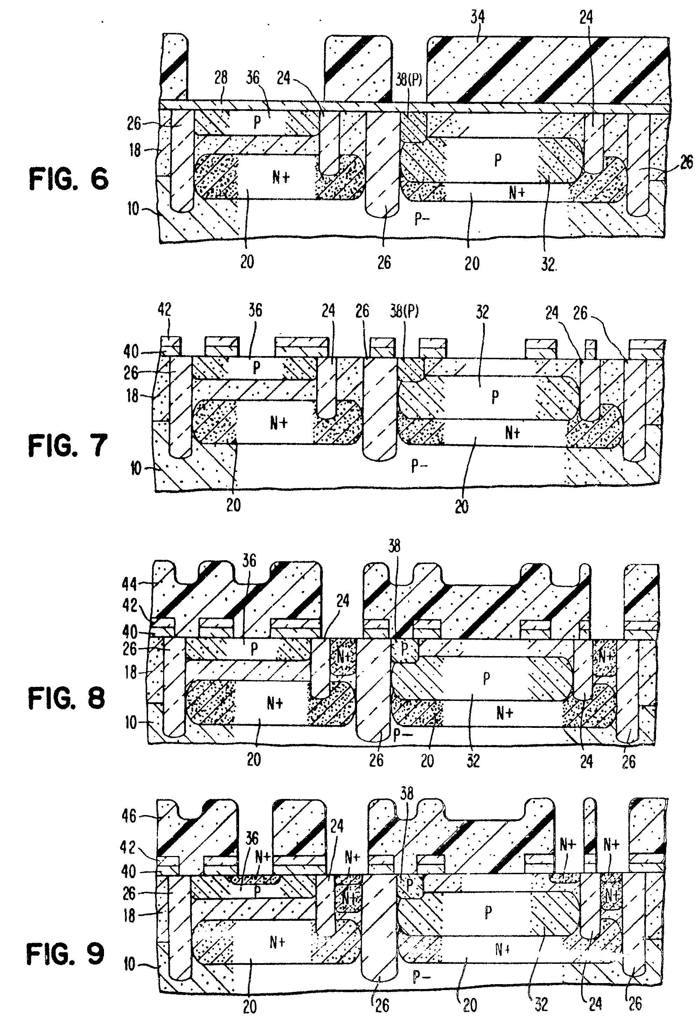

Im durch die Fig. 6 veranschaulichten Prozeßschritt werden die Basis des NPN-Transistors und gleichzeitig die Emitteranschlußzone des PNP-Transistors gebildet. Dazu wird wiederum eine entsprechende Photolackmaske 34 mit den erforderlichen Fenstern in konventioneller Weise auf die Siliziumdioxidschicht 28 aufgebracht. Es erfolgt erneut eine Implantation von Bor, so daß die P-dotierte Basis 36 und gleichzeitig die P-dotierte Emitteranschlußzone 38 entstehen. Anschließend wird die Photolackschicht 34 entfernt und ein Temperaturzyklus durchgeführt.

Im Prozeßschritt gemäß Fig. 7 wird zunächst mit einem geeigneten Ätzmittel die Siliziumdioxidschicht 28 entfernt. Anschließend wird erneut eine Siliziumdioxidschicht 40 thermisch aufgebracht. Darauf wird in einem chemischen Aufdampfprozeß eine Siliziumnitridschicht 42 niedergeschlagen. Auf diese Siliziumnitridschicht wird zusätzlich eine nicht dargestellte, dünne weitere Siliziumdioxidschicht aufgebracht. Auf konventionellen, photolithographischem Wege werden in dieser letzten Siliziumdioxidschicht an geeigneten Stellen Fenster freigelegt, durch die dann in einem weiteren Ätzpropeß entsprechende Fenster in der Siliziumnitridschicht 42 geöffnet werden. Die oberste Siliziumdioxidschicht wird nunmehr entfernt. Die verbleibende Siliziumnitridschicht 42 dient als Maske zum Ätzen der untersten Siliziumdioxidschicht 40. Die auf diese Weise gebildeten Fenster legen die Oberflächenbereiche frei, in denen die elektrischen Kontakte, der Emitter des NPN-Transistors und die N+-dotierten Anschlußzonen der NPN- und PNP-Transistoren einzubringen sind. Zunächst wird eine Photolackmaske 44 aufgebracht, die im Bereich der einzubringenden Anschlußzonen Fenster aufweist. In einem anschließenden Implantationsprozeß werden dann die N+-dotierten Anschlußzonen erzeugt. Die Photolackschicht 44 wird entfernt. Eine anschließend aufgebrachte weitere Photolackmaske 46 weist ein Fenster im Bereich des zu bildenden Emitters des NPN-Transistors auf. Außerdem sind Fenster im Bereich der zu bildenden Kollektoranschlußzone des NPN-Transistors, des Basiskontaktes des PNP-Transistors und der N-leitenden Anschlußzone des PNP-Transistors vorhanden (Fig. 9). Durch Implantation von Arsenionen werden die entsprechenden Zonen eingebracht. Die Photolackschicht 46 wird dann abgeätzt. Es erfolgt erneut ein Temperaturzyklus, wie er im Anschluß an lonenimplantationsprozesse üblich ist.

Schließlich wird eine zur Bildung ohmscher Kontakte geeignete Metallschicht auf die Gesamtoberfläche der Anordnung aufgebracht. Typische Kontaktmaterialien sind Aluminium oder Aluminium-Kupfer. Daneben sind auch Materialien wie Platin, Palladium, Molybdän usw. anwendbar. Auf photolithographischem Wege wird dann aus dieser Metallschicht das gewünschte Leitungs- bzw. Kontaktmuster gebildet, indem nicht benötigte Schichtbereiche abgeätzt werden.

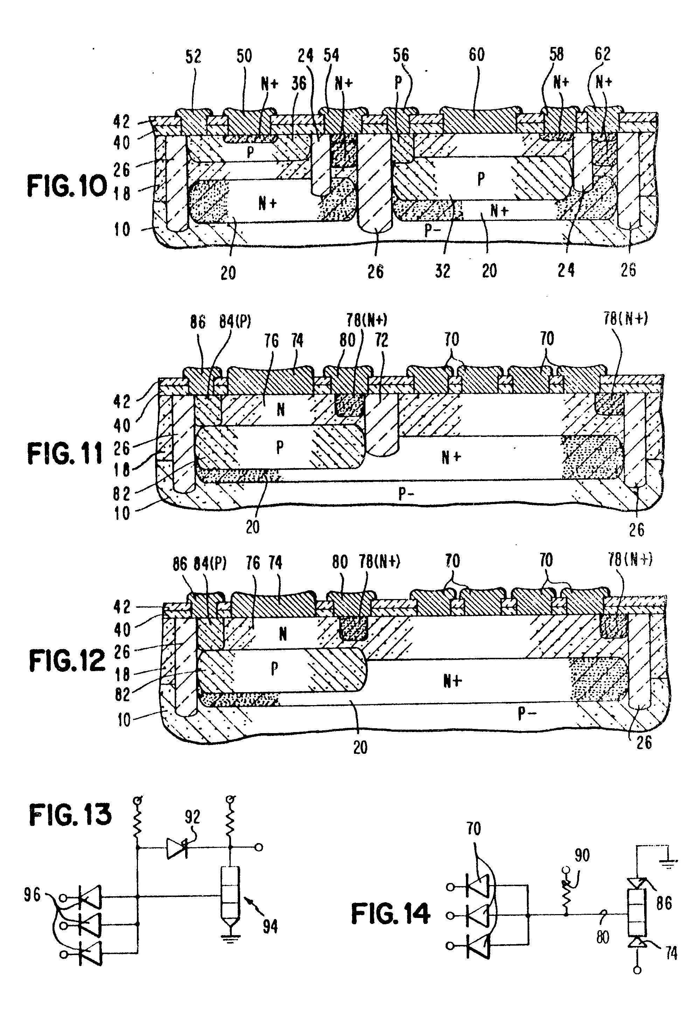

Die Fig. 10 zeigt die komplette NPN-, PNP-Transistorstruktur mit dem Emitterkontakt 50, dem Basiskontakt 52 und dem Kollektoranschlußkontakt 54 des NPN-Transistors und dem Emitterkontakt 56, dem Basiskontakt 58, dem Schottky-Kollektorkontakt 60 und dem Sperrschicht-Isolationskontakt 62 des PNP-Transistors. Dabei ist zu bemerken, daß das aufgebrachte Kontaktmaterial mit der N-dotierten Epitaxieschicht 18 einen Schottkykontakt bildet, so daß der PNP-Transistor mit einem Schottky-Kollektor ausgestattet ist.

In den Fig. 11 und 12 ist die integrierte Kombination eines PNP-Transistors und mehrerer Schottky-Dioden 70 dargestellt. Der PNP-Transistor setzt sich aus einem Schottky-Kollektor 74, einer Basis 76, einer N+-dotierten Basisanschlußzone 78, einem Basisanschluß 80, einem Emitter 82, einer Emitteranschlußzone 84 und einem Emitteranschluß 86 zusammen. Der Unterschied zwischen den Anordnungen der Fig. 11 und 12 besteht darin, daß im Falle der Fig. 11 eine Isolationszone 72 vorgesehen ist, die bis in die vergrabene N+-dotierte Zone 20 reicht und den für die Schottky-Dioden 70 vorgesehenen Oberflächenbereich von den für den Transistor vorgesehenen Oberflächenbereich isoliert. Auf diese Weise erhält man einen isolierten PNP-Transistor.

Die Herstellung der Schottky-Dioden 70 kann in folgender Weise erfolgen: Zunächst wird der Kontaktbereich für den Schottky-Kollektor 74 freigelegt und ein Metall, wie beispeislsweise Platin, Palladium usw. aufgebracht, die mit N-leitendem Silizium eine hohe Barriere ergeben. Die Anordnung wird dann in einer inerten Umgebung bei etwa 450 bis 550°C und einer Dauer von 15 bis 30 Min. gesintert, wobei sich PtSi bzw. PdSi bildet. Das auf der Oxidschicht vorhandene Metall wird entfernt. Die Kontaktbereiche für die Dioden 70 werden anschließend freigelegt. Nunmehr wird ein Metall wie Ti, Ta, Ti-W usw. aufgedampft, das mit N-leitendem Silizium eine niedrige Barriere ergibt. Auf diese dünne Schicht, üblicherweise in der Größenordnung von 200 bis 500 nm, wird als stromleitendes Metall Al-Cu aufgedampft. In diese Schicht werden geeignete Muster geätzt, so daß das gewünschte Leitungsmuster entsteht. Nach einer erneuten Sinterung in einer inerten Umgebung bei einer Temperatur von 400 bis 500°C und einer Dauer von 20 bis 30 Min. erhält man die angestrebten Schottky-Dioden.

Eine konventionelle Dioden-Transistor-Logik ist in Fig. 13 dargestellt. Die Schottky-Diode 92 mit hoher Barriere verhindert die Sättigung des Transistors 94. Die Eingangsdioden 96 weisen eine niedrigere Barrierenhöhe auf. In Fig. 14 ist das Ersatzschaltbild der Kombination aus Schottky-Dioden und PNP-Transistor der Fig. 11 und 12 dargestellt. Bei dem Widerstand 90 handelt es sich um einen externen Widerstand. Bei der erfindungsgemäßen Anordnung bilden die Schottky-Dioden 70 mit niedriger Barrierenhöhe und der PNP-Transistor mit Schottky-Kollektor die Dioden-Transistor-Logik. Der Transistor geht nicht in Sättigung, so daß sich hier eine zusätzliche sättigungsverhindernde Diode erübrigt. Man erhält also mit dieser Art von Logik eine erhöhte Packungsdichte.

**Patentansprüche**

1. Integrierte Halbleiteranordnung mit vertikalen PNP- und NPN-Strukturen, bei der jede der Strukturen in einem von durch Isolationszonen (26) getrennten Bereichen einer auf ein Substrat (10) eines ersten Leitungstyps (P) aufgebrachten Epitaxieschicht (18) des entgegengesetzten zweiten Leitungstyps (N) angeordnet ist, bei der innerhalb wenigstens eines Bereiches im Grenzgebiet zwischen Substrat (10) und Epitaxieschicht (18) eine vergrabene Zone (20) des zweiten Leitungstyps (N) vorhanden ist und bei der in einem ersten Bereich eine vergrabene Zone (32) des ersten Leitungstyps (P) angeordnet und über eine gleichartig dotierte Anschlußzone (33) an die Oberfläche geführt ist, dadurch gekennzeichnet,
daß die vergrabene Zone (32) des ersten Leitungstyps durch Implantation hergestellt ist und als Emitter eines invers betriebenen Transistors dient,
daß die Anschlußzone die Emitteranschlußzone (38) darstellt und
daß auf der Oberfläche der die Basis des invers betriebenen Transistors bildenden Epitaxieschicht (18) ein einen Schottky-Kollektor bildender Metallkontakt (60) angeordnet ist.

2. Integrierte Halbleiteranordnung nach Anspruch 1, dadurch gekennzeichnet,
daß in einem zweiten Bereich die vergrabene Zone (20) des zweiten Leitungstyps (N) als Subkollektor eines Transistors dient und über eine gleichartig dotierte Kollektoranschlußzone an die Oberfläche geführt ist und
daß seitlich von dieser Kollektoranschlußzone die Basiszone (36) des ersten Leitungstyps (P) und in dieser die Emitterzone des zweiten Leitungstyps (N) angeordnet ist.

3. Integrierte Halbleiteranordnung nach Anspruch 1, dadurch gekennzeichnet,
daß die vergrabene Zone (20) des zweiten Leitungstyps (N) im ersten Bereich über eine gleichartig dotierte Anschlußzone an die Oberfläche geführt ist und mit dem Substrat (10) einen die Isolation bewirkenden, sperrenden PN-Übergang bildet.

4. Integrierte Halbleiteranordnung nach den Ansprüchen 1, 2 oder 3, dadurch gekennzeichnet,
daß im ersten Bereich seitlich von der Struktur des invers betriebenen Transistors an der Oberfläche der Epitaxieschicht (18) Schottky-Dioden (70) gebildet sind, die mit dem Transistor zu einer Schaltung vereinigt sind.

5. Integrierte Halbleiteranordnung nach Anspruch 4, dadurch gekennzeichnet,
daß die Schottky-Dioden (70) über die ihre eine gemeinsame Elektrode bildende Epitaxieschicht (18) mit der Basis des Transistros verbunden sind und mit diesem eine Dioden-Transistor-Logik bilden.

6. Integrierte Halbleiteranordnung nach den Ansprüchen 1 bis 5, dadurch gekennzeichnet,
daß die Isolationszonen (26) aus in die Epitaxieschicht (18) eingebrachtem dielektrischem Material bestehen.

7. Integrierte Halbleiteranordnung nach Anspruch 6, dadurch gekennzeichnet,
daß die Isolationszonen (26) aus Siliziumdioxid bestehen.

8. Integrierte Halbleiteranordnung nach den Ansprüchen 1 bis 7, dadurch gekennzeichnet,
daß der Schottky-Kollektor aus einem Metallkontakt (60) aus PtSi besteht.

9. Integrierte Halbleiteranordnung nach den Ansprüchen 1 bis 7, dadurch gekennzeichnet,

daß die Schottky-Dioden (70) aus Ti/Al + Cu und der den Schottky-Kollektor bildende Metallkontakt (60) aus PtSi/Ti/Al + Cu bestehen.

10. Verfahren zum Herstellen der Halbleiteranordnung nach den Ansprüchen 1 bis 9, dadurch gekennzeichnet,
daß in das Halbleitersubstrat (10) des ersten Leitungstyps hochdotierte Zonen (20) des zweiten Leitungstyps eingebracht werden,
daß darauf auf die Oberfläche des Substrats (10) die Epitaxieschicht (18) des zweiten Leitungstyps aufgewachsen wird,
daß anschließend in die Epitaxieschicht (18) die vergrabenen, hochdotierten Zonen (20) des zweiten Leitungstyps umgebende Isolationszonen (26) eingebracht werden, und daß danach innerhalb des ersten Bereichs die als Emitter des invers betriebenen Transistors dienende, vergrabene Zone (32) des ersten Leitungstyps durch Ionenimplantation eingebracht, die Emitteranschlußzone (38) in die Epitaxieschicht (18) eingebracht wird und der den Schottky-Kollektor bildende Metallkontakt auf die Epitaxieschicht (18) aufgebracht wird.

11. Verfahren nach Anspruch 10, dadurch gekennzeichnet,
daß nach dem Einbringen der als Emitter des invers betriebenen Transistors dienenden, vergrabenen Zone (32) des ersten Leitungstyps in den ersten Bereich die Emitteranschlußzone (38) und gleichzeitig in den zweiten Bereich die Basiszone (36) des ersten Leitungstyps eingebracht werden,
daß dann gleichzeitig im zweiten Bereich die Emitterzone und im ersten Bereich die Basisanschlußzone des zweiten Leitungstyps eingebracht werden und
daß darauf im ersten Bereich der den Schottky-Kollektor bildende Metallkontakt (60) aufgebracht wird.

### Claims

1. Integrated semiconductor device with vertical PNP and NPN structures, wherein each of the structures is located in one of the regions, isolated form each other by isolation zones (26), of an epitaxial layer (18) of the second conductivity type (N) applied to a substrate (10) of a first conductivity type, wherein in at least one region at the interface between substrate (10) and epitaxial layer (18) there ist a buried zone (20) of the second conductivity type (N), and wherein a buried zone (32) of the first conductivity type (P) is located in a first region and is connected to the surface via a similarly doped reach-through (38), characterized in that the buried zone (32) of the first conductivity type is produced by implantation, serving as an emitter of an inversely operated transistor, that the reach-through represents the emitter reach-through (38), and that a metal contact (60) forming a Schottky collector is located on the surface of the epitaxial layer (18) forming the base of the inversely operated transistor.

2. Integrated semiconductor device in accordance with claim 1, characterized in that in a second region the buried zone (20) of the second conductivity type (N) serves a subcollector of a transistor and is connected to the surface via a similarly doped collector reach-through, and that laterally to sid collector reach-through the base zone (36) of the first conductivity type (P) is located and the emitter zone of the second conductivity type (N) is located in said bse zone.

3. Integrated semiconductor device in accordance with claim 1, characterized in that the buried zone (20) of the second conductivity type (N) in the first region is connected to the surface via a similarly doped reach-through, forming an isolating PN barrier junction with the substrate (10).

4. Integrated semiconductor device in accordance with claims 1, 2 or 3, characterized in that the first region laterally to the structure of the inversely operated transistor, Schottky diodes (70), which are combined with the transistor to form a circuit, are formed on the surface of the epitaxial layer (18).

5. Integrated semiconductor device in accordance with claim 4, characterized in that the Schottky diodes (70), via the epitaxial layer (18) forming their common electrode, are connected to the base of the transistor, forming a diode-transistor logic therewith.

6. Integrated semiconductor device in accordance with claims 1 to 5, characterized in that the isolation zones (26) consist of dielectric material introduced into the epitacial layer (18).

7. Integrated semiconductor device in accordance with claim 6, characterized in that the isolation zones (26) are composed of silicon dioxide.

8. Integrated semiconductor device in accordance with claums 1 to 7, characterized in that the Schottky collector is made up of a metal contact (60) of PtSi.

9. Integrated semiconductor device in accordance with claims 1 to 7, characterized in that the Schottky diodes (70) are composed of Ti/Al + Cu and the metal contact (60) forming the Schottky collector is composed of PtSi/Ti/Al + Cu.

10. Method for fabricating the semiconductor device in accordance with claims 1 to 9, characterized in that highly doped zones (20) of the second conductivity type are instroduced into the semiconductor substrate (10) of the first conductivity type, that the epitaxial layer (18) of the second conductivity type is then grown on the surface of the substrate (10), that isolation zones (26), surrounding the buried, highly doped zones (20) of the second conductivity type, are then introduced into the epitaxial layer (18), and that subsequently the buried zone (32) of the first conductivity type serving as the emitter of the inversely operated transistor ist ion-implanted into the first region, the emitter reach-through (38) is introduced into the epitaxial layer (18), and the metal contact forming the Schottky collector is applied to the epitaxial layer (18).

11. Method in accordance with claim 10, characterized in that after the buried zone (32) of the first conductivity type serving as an emitter of the inversely operated transistor has been introduced, the emitter reach-through (38) and the base zone (36) of the first conductivity type are simultaneously introduced into the first and the second region, respectively, that the emitter zone and the base reach-through of the second conductivity type are simultaneously introduced into the second and the first region, respectively, and that the metal contact (60) forming the Schottky collector is then applied to the first region.

## Revendications

1. Dispositif semi-conducteur intégré à structures verticales PNP et NPN, dans lequel chacune des structures est disposée dans une des régions, séparées les unes des autres par des zones d'isolement (26), d'une couche épitaxiale (18) du second type de conductivité (N) déposées sur un substrat (10) du premier type de conductivité, dans lequel au moins une région à l'interface entre le substrat (10) et la couche épitaxiale (18) présente une région enterrée (20) du second type de conductivité (N), et dans lequel est disposée dans une première région une région enterrée (32) du premier type de conductivité (P) qui est reliée à la surface par une région de traversée de même type de conductivité (38), caractérisé en ce que la région enterrée (32) du premier type de conductivité est obtenue par implantation et sert d'émetteur pour un transistor fonctionnant en inverse, en ce que la région de traversée représente la région de traversée de l'émetteur (38), et en ce qu'un contact métallique (60) formant un collecteur de Schottky est disposé sur la surface de la couche épitaxiale (18) qui forme la base du transistor fonctionnant en inverse.

2. Dispositif semi-conducteur intégré selon la revendication 1, caractérisé en ce que dans une seconde région la région enterrée (20) du second type de conductivité (N) sert de sous-collecteur d'un transistor et qu'elle est reliée à la surface par une région de traversée de collecteur du même type de conductivité, et en ce que la région de base (36) du premier type de conductivité (P), est disposée latérallement par rapport à cette région de traversée de collecteur, et que la région d'émetteur du second type de conductivité (N) est disposée dans la région de base.

3. Dispositif semi-conducteur intégré selon la revendication 1, caractérisé en ce que la région enterrée (20) du second type de conductivité (N) dans la première région est reliée à la surface par une région de traversée de même type de conductivité et forme avec le substrat (10) une jonction PN de blocage isolante.

4. Dispositif semi-conducteur intégré selon la revendication 1, 2 ou 3, caractérisé en ce qu'à la surface de la couche épitaxiale (18), des diodes de Schottky (70) combinées avec ledit transistor puor constituer un circuit, sont formées dans la première région, latéralement par rapport à la structure du transistor fonctionnant en inverse.

5. Dispositif semi-conducteur intégré selon la revendication 4, caractérisé en ce que les diodes de Schottky (70) sont reliées à travers la couche épitaxiale (18) qui forme leur électrode commune, à la base du transistor et constituent avec celui-ci, un circuit logique du type diode-transistor.

6. Dispositif semi-conducteur intégré selon l'une quelconque des revendications 1 à 5, caractérisé en ce que les régions d'isolement (26) sont composées d'un matériau diélectrique formé dans la couche épitaxiale (18).

7. Dispositif semi-conducteur intégré selon la revendication 6, caractérisé en ce que les régions d'isolement (26) sont en dioxyde de silicium.

8. Dispositif semi-conducteur intégré selon l'une quelconque des revendications 1 à 7, caractérisé en ce que le collecteur de Schottky est composé d'un contact métallique (60) à base de PtSi.

9. Dispositif semi-conducteur intégré selon l'une quelconque des revendications 1 à 7, caractérisé en ce que les diodes de Schottky (70) comportent du Ti/Al+Cu et que le contact métallique (60) formant le collecteur de Schottky comporte du PtSi/Ti/Al+Cu.

10. Procédé pour fabriquer un dispositif semi-conducteur selon l'une quelconque des revendications 1 à 9, caractérisé en ce que l'on diffuse dans le substrat semi-conducteur (10) du premier type de conductivité des régions à dopage élevé (20) du deuxième type de conductivité, en ce que l'on fait croître sur la surface du substrat (10) la couche épitaxiale (18) du second type de conductivité, en ce que l'on diffuse ensuite dans la couche épitaxiale (18) les couches d'isolement (26) entourant les régions enterrées à dopage élevé (20) du second type de conductivité, et en ce que l'on diffuse finalement dans la première région, la région enterrée (32) du premier type de conductivité servant d'émetteur du transistor fonctionnant en inverse à l'aide d'une implantation ionique, que l'on diffuse la région de contact d'émetteur (38) dans la couche épitaxiale (18) et que l'on dépose enfin le contact métallique formant le collecteur de Schottky sur la couche épitaxiale (18).

11. Procédé selon la revendication 10, caractérisé en ce qu'après la diffusion de la région enterrée (32) du premier type de conductivité servant d'émetteur du transistor fonctionnant en inverse, l'on diffuse la région de contact d'émetteur (38) dans la première région et simultanément la région de base (36) du premier type de conductivité dans la seconde région, en ce que l'on diffuse en même temps la région d'émetteur dans la seconde région et la région de contact de base du second type de conductivité dans la première région, et en ce que l'on dépose ensuite dans la première région le contact métallique (60) formant le collecteur de Schottky.

FIG. 1

FIG. 2

FIG. 3

FIG. 4

FIG. 5

FIG. 6

FIG. 7

FIG. 8

FIG. 9

FIG.10

FIG.11

FIG.12

FIG.13

FIG.14